# EUROPEAN PATENT SPECIFICATION

(11) **EP 1 706 775 B1**
(45) Date of publication and mention of the grant of the patent: **26.11.2008**
(21) Application number: 05706015.4
(22) Date of filing: 21.01.2005
(51) Int. Cl.: G02B 26/10

(54) **SYSTEM AND METHOD FOR OPTIMIZING CHARACTER MARKING PERFORMANCE**
SYSTEM UND VERFAHREN ZUM OPTIMIEREN DER ZEICHENMARKIERUNGSLEISTUNG
SYSTEME ET PROCEDE D'OPTIMISATION DES PERFORMANCES DE MARQUAGE DE CARACTERES

(30) Priority: 23.01.2004 US 538842 P; 28.05.2004 US 575255 P; 28.09.2004 US 613962 P
(43) Date of publication of application: 04.10.2006
(73) Proprietor: GSI Group Corporation, Billerica, MA 01821 (US)
(72) Inventor: HUANG, Yuhong, Acton, MA 01720 (US)
(74) Representative: Valea AB
(86) International application number: PCT/US2005/002009
(87) International publication number: WO 2005/073783

(56) References cited:
- EP-A- 0 339 402
- WO-A-03/097290
- US-A- 4 532 402
- US-A- 5 185 676
- US-A- 5 646 765
- US-A- 6 107 600
- US-B1- 6 256 121
- US-B1- 6 646 397
- PATENT ABSTRACTS OF JAPAN vol. 2000, no. 04, 31 August 2000 (2000-08-31) -& JP 2000 028955 A (MITSUBISHI ELECTRIC CORP), 28 January 2000 (2000-01-28)
- PATENT ABSTRACTS OF JAPAN vol. 013, no. 545 (M-902), 6 December 1989 (1989-12-06) -& JP 01 224189 A (NIKON CORP), 7 September 1989 (1989-09-07)
- PATENT ABSTRACTS OF JAPAN vol. 017, no. 325 (E-1384), 21 June 1993 (1993-06-21) -& JP 05 036851 A (NEC YAMAGUCHI LTD), 12 February 1993 (1993-02-12)

## Description

### BACKGROUND

The present invention generally relates to limited rotation motor systems, and relates in particular to systems for designing limited rotation motor systems.

Limited rotation motors generally include stepper motors and constant velocity motors. Certain stepper motors are well suited for applications requiring high speed and high duty cycle sawtooth scanning at large scan angles. For example, U.S. Patent No. 6,275,319 discloses an optical scanning device for raster scanning application, and U.S. Patent No. 6,107,600 discloses a laser machining apparatus.

Limited rotation motors for certain applications, however, require the rotor to move between two positions with a precise and constant velocity rather than by stepping and settling in a sawtooth fashion. Such applications require that the time needed to reach the constant velocity be as short as possible and that the amount of error in the achieved velocity be as small as possible. Constant velocity motors generally provide a higher torque constant and typically include a rotor and drive circuitry for causing the rotor to rotate about a central axis, as well as a position transducer, e.g., a tachometer or a position sensor, and a feedback circuit coupled to the transducer that permits the rotor to be driven by the drive circuitry responsive to an input signal and a feedback signal. For example, U.S. Patent No. 5,424,632 discloses a conventional two-pole limited rotation motor.

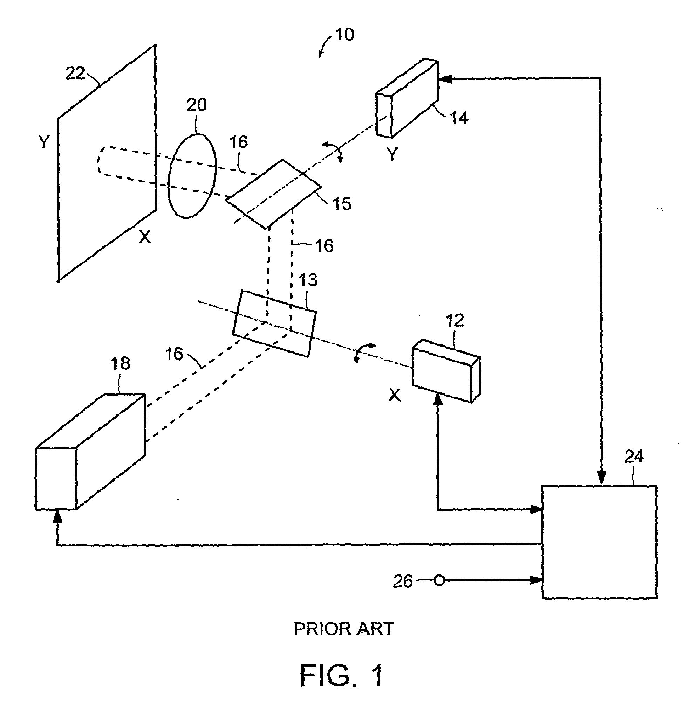

Figure 1 shows a marking system 10 that employs two limited rotation motors 12, 14 that are coupled to mirrors 13 and 15 respectively for guiding a laser beam 16 that is produced by a laser source 18 through an imaging lens 20 toward an imaging surface 22. The control of the x scan direction motor 12 and the *y* scan direction motor 14, as well as the turning on and off of the laser source 18 is provided by a controller 22. The controller 24 receives input commands 26 regarding a mark that is to be made on the imaging surface. The controller 24 then directs the x scanner 14 and the *y*-scanner 12 to move accordingly, and to turn on and off the laser source (e.g., to switch between a low and high or above a marking threshold value) responsive to the input command and responsive to the movement of the imaging surface at the target plane. The system may also include position detectors within each motor 12 and 14 that each provide position detection signals back to the controller 24.

Such limited rotation motors may be used, for example, in a variety of laser scanning applications, such as high speed surface metrology. Further laser processing applications include laser welding (for example high speed spot welding), surface treatment, cutting, drilling, marking, trimming, laser repair, rapid prototyping, forming microstructures, or forming dense arrays of nanostructures on various materials.

The processing speeds of such systems are typically limited by one or more of mirror speed, X-Y stage speed, material interaction and material thermal time constants, the layout of target material and regions to be processed, and software performance. Generally, in applications where one or more of mirror speed, position accuracy, and settling time are factors that limit performance, any significant improvement in scanning system open loop gain may translate into immediate throughput improvements.

In the limited rotation motor actuator, the open-loop gain is determined by the torque constant of the motor, the inertia of the mirror and rotor structure, and the gain characteristics of the power amplifier. Change in the design of the system, such as changes of head from one size to another size, may cause significant changes in total inertia, and consequently the open-loop gain. Such systems, however, typically must be designed and constructed in order to fully evaluate their performance.

There is a need, therefore, for improved limited rotation motor system, and more particularly, there is a need for optimizing the performance of limited rotation motors.

### SUMMARY

The invention provides an optimization system for optimizing the performance of a laser marking system. The optimization system includes the features set out in claim 1. The invention also provides a method of optimizing the performance of a laser marking system as defined in independent claim 10.

### BRIEF DESCRIPTION OF THE DRAWINGS

The following description may be further understood with reference to the accompanying drawings in which:
Figure 1 shows an illustrative diagrammatic view of a scanning or marking system of the prior art;
Figure 2 shows an illustrative diagrammatic view of marking and jump vectors for forming the letter A in accordance with an embodiment of the invention;
Figures 3A and 3B show diagrammatic illustrative views of the *x* and *y* position commands over time in forming the mark shown in Figure 2;
Figures 4A and 4B show diagrammatic illustrative views of the *x* and y actual motor commands responsive to the position commands of Figures 3A and 3B for a set of marking parameters;
Figure 5 shows an illustrative diagrammatic view of a mark formed by the actual motor commands shown in Figures 4A and 4B;
Figures 6A and 46B show diagrammatic illustrative views of the x and *y* actual motor commands responsive to the position commands of Figures 3A and 3B for another set of marking parameters;
Figure 7 shows an illustrative diagrammatic view of a mark formed by the actual motor commands shown in Figures 6A and 6B;
Figures 8A and 8B show illustrative diagrammatic views of character marking in a system in accordance with an embodiment of the invention at relatively low and high speeds;
Figure 9 shows an illustrative diagrammatic view of the identification of error vectors in quantifying the quality of a mark in accordance with an embodiment of the invention;
Figure 10 shows an illustrative diagrammatic view of the identification of error vectors in quantifying the quality of another mark in accordance with an embodiment of the invention;
Figure 11 shows an illustrative diagrammatic graphical representation of marking quality quantification analyses in accordance with certain embodiments of the invention;
Figure 12 shows an illustrative diagrammatic graphical representation of a marking speed optimization mapping in accordance with an embodiment of the invention;
Figure 13 shows an illustrative diagrammatic graphical representation of a marking speed optimization mapping in accordance with another embodiment of the invention;
Figures 14A - 14C show illustrative diagrammatic views of markings at different parameter settings in accordance with an embodiment of the invention;
Figures 15A and 15B show illustrative diagrammatic views of markings employing further parameter settings in accordance with an embodiment of the invention; and
Figure 16 shows an illustrative diagrammatic view of a virtual marking system in accordance with an embodiment of the invention.

The drawings are shown for illustrative purposes only.

### DETAILED DESCRIPTION OF THE ILLUSTRATED EMBODIMENTS

In accordance with various embodiments of the invention, motor performance in a limited rotation motor system is optimized either for speed or for quality by identifying a particular combination of marking speed (MS), marking delay (MD), jump speed (JS), jump delay (JD), and Laser on-off delay (Lon/off) that achieves the highest speed or quality. The combination of factors that yields the output performance is identified by obtaining a real or virtual image, and comparing the real or virtual image with the input commands for a particular mark or character. The comparison identifies a set of differences between the input data and the real or virtual image for a collection of points on the input data. The system then either obtains an average of the differences for a mark or character (average marking error) or obtains the largest single marking error (maximum marking error). The combination of factors (MS, MD, JS, JD, Lon/Loff) that yields the smallest error for either speed or quality is then chosen.

A system and method, therefore, are provided to optimize the performance of a two-dimensional laser marking system. The marking system in accordance with an embodiment includes two optical scanners. Each scanner includes a limited rotation motor as the actuator. An optimization technique based on this is performed by marking simulations with a model derived from a marking head. For a given pattern, the optimized command sets are determined from simulated marking results of all practical settings of command parameters. Marking quality optimization is achieved by choosing the best quality marking among all markings of the same speed, while marking speed optimization is obtained by searching the highest marking speed that maintains a specified marking quality. Simulation and experimental results show up to 40% improvement in the marking speed, or four times improvement on marking quality, as compared with the standard zero mark command sets.

Laser marking systems are widely used in industries with applications ranging from marking labels on the semiconductor wafer to engines of very large trucks. In these applications, marking is performed by deflecting the incoming laser beam with two individually controlled mirrors to create horizontal and vertical movements of the beam spot on the marking surface. Usually the mirrors are driven by a specially designed direct current (DC) limited rotation torque motor sometimes called a galvanometer. The speed of marking a given pattern is limited by the speed of the servo system with the motor. With the continuing demand for more efficient production of limited rotation motors, improving the marking speed while maintaining a specified marking quality has become a challenge for marking system designs and users.

From a control system perspective, a laser marking system may be characterized as a servo motor system wherein the marking laser beam is required to follow faithfully to the set of marks that draw the desired pattern. Although the quality of the marking is related to the overall tracking errors, it is the differences between the reference marking pattern and the actual marking that determines the quality of the marking. Since the actual marking consists of only portions of the overall time response of the scanner movement, the optimization schemes that minimize overall tracking errors may not result in the optimal marking performance of the marking system.

Two functions proposed herein may be used in accordance with various embodiments of the invention to evaluate the performance of the marking system based on the quality of the actual marking: these are the maximum marking error (MME) and the average marking error (AME).

To generate the marking commands for a given marking pattern, the pattern may be broken up into small line segments called marks. Each mark includes a constant speed ramp command followed by a fixed delay time. The speed of the ramp is called Mark Speed (MS), and the delay time is called Mark Delay (MD). Methods are proposed herein to select the optimal MS and MD setting for a given marking head and marking pattern using marking quality evaluation functions.

An X-Y laser marking system in accordance with an embodiment includes two scanners. The horizontal axis of the marking spot may be defined as the X-axis and the vertical axis may be defined as the Y-axis. The scanner in each axis consists of a limited rotation torque as the actuator, a mirror as a beam deflecting device and associated control and driver electronics. A focusing lens may also be inserted in the beam path between the target plane and the Y-axis mirror to reduce the spot size and increase the energy density of the laser spot.

During laser marking, the laser beam is projected from the laser head onto the target to be marked, called marking plane. The X and Y mirrors in the path of the laser beam control the position of the beam spot on the marking plane by the rotation angles of the X and Y scanner, respectively. Marks are created at the interaction points between the target material and the laser.

The position reference commands to each scanner for marking a given pattern are continuous waveforms of desired angular positions of the X and Y scanner. These position reference commands are generated from a set of stroke vectors and the mark speed and mark delay settings. Each stroke vector is a straight-line segment from which the whole pattern is constructed. If we project the pattern on the complex plane, the segments may be visualized as a vector with the direction of the vector represents the moving direction of the laser beam during marking. Since the pattern to be marked is represented by a sequence of small vectors, this type of laser marking is also called vector marking.

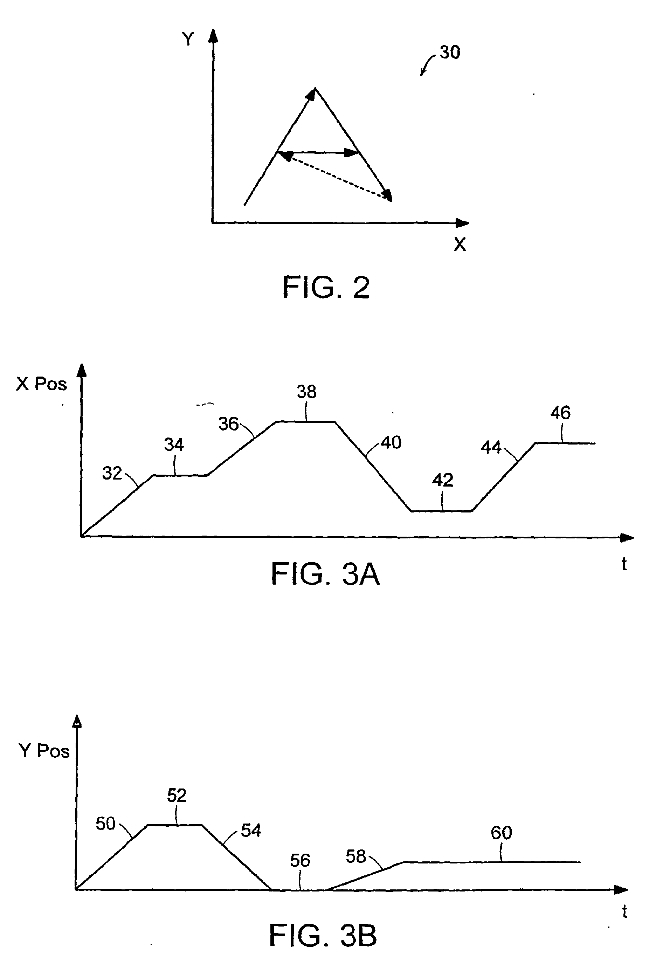

For example, the sequence of vectors that results in capital letter A is shown at 30 in Figure 2. Each vector is then converted into a ramp signal in the time domain with ramp speed controlled by mark speed (MS). At the end of each ramp command, there is an optional stop period, defined as mark delay (MD). Figure 3A shows the X-axis commands for marking the letter A in Figure 2. In particular, as shown in Figure 3A, the scanner moves the beam along the X-axis for a first time period as shown at 32, the stops for a delay period as shown at 34, then marks again in the positive direction along the X-axis as shown at 36, then rests as shown at 38, then moves in the negative direction along the X-axis as shown at 40, then rests as shown at 42, and then marks in the positive direction along the X-axis as shown at 44, and then rests as shown at 46.

Figure 3B shows the Y-axis commands for marking the letter A in Figure 2. In particular, as shown in Figure 3B, the scanner moves the beam along the Y-axis for a first time period as shown at 50, the stops for a delay period as shown at 52, then marks in the negative direction along the Y-axis as shown at 54, then rests as shown at 56, then moves in the positive direction along the Y-axis as shown at 58, then rests as shown at 60.

Note that the MS and MD settings are global settings. In other words, the same MS and MD values are used for all the vectors in the pattern. The total time from the beginning of marking to the end of marking determines the speed of marking the given pattern. Larger MS and smaller MD for the same vector sequence results in higher marking speed, but larger MS may also result in significant degradation of quality.

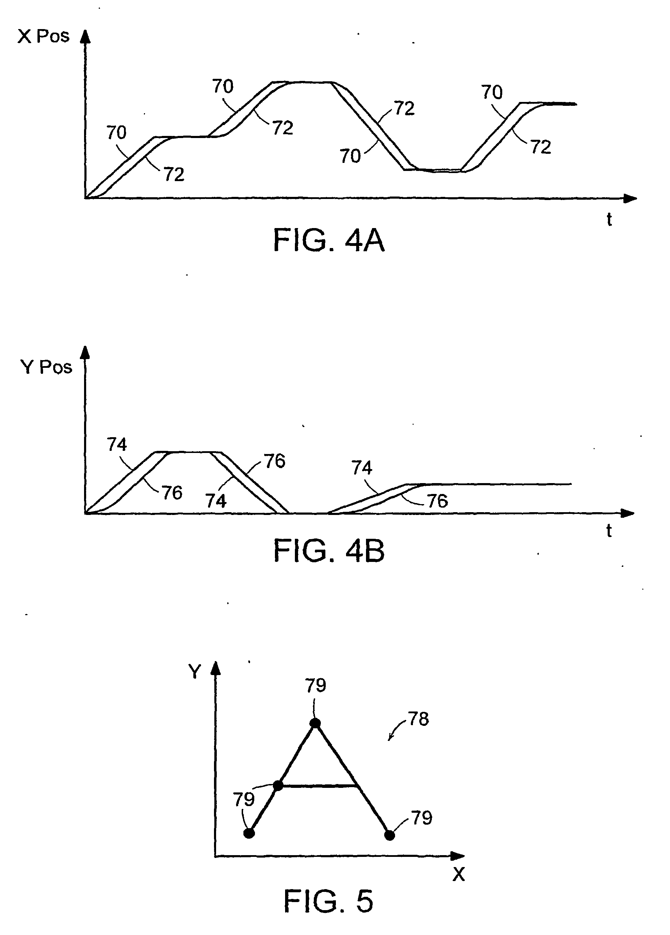

For example, Figures 4A and 4B show desired and actual marking commands for forming the marking A shown in Figure 2. Figure 4A shows the marking commands 70 and resulting actual commands 72 for the X-axis when the mark delay (MD) is increased. Figure 4B shows the marking commands 74 and resulting actual commands 76 for the Y-axis when the mark delay (MD) is increased. As shown at 78 in Figure 5, the mark resulting from the actual commands shown at 72 and 76 in Figures 4A and 4B result in a mark that has areas of increased radiation (as shown at 79) associated with the areas of the delays.

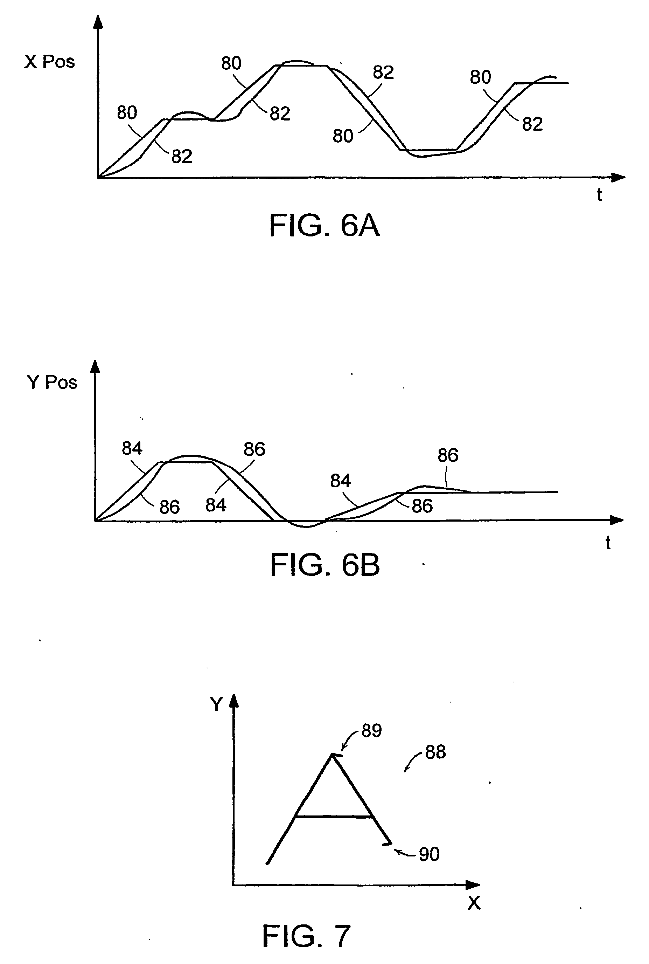

Figures 6A and 6B show desired and actual marking commands for forming the marking A shown in Figure 2 in which the mark speed (MS) is increased. Figure 6A shows the marking commands 80 and resulting actual commands 82 for the X-axis when the mark speed (MS) is increased, and Figure 6B shows the marking commands 84 and resulting actual commands 86 for the Y-axis when the mark speed (MS) is increased. As shown at 88 in Figure 7, the mark resulting from the actual commands shown at 82 and 86 in Figures 6A and 6B result in a mark that has overruns (as shown for example at 89) and under-marking (as shown at 90). A balance between these extremes, therefore is desirable.

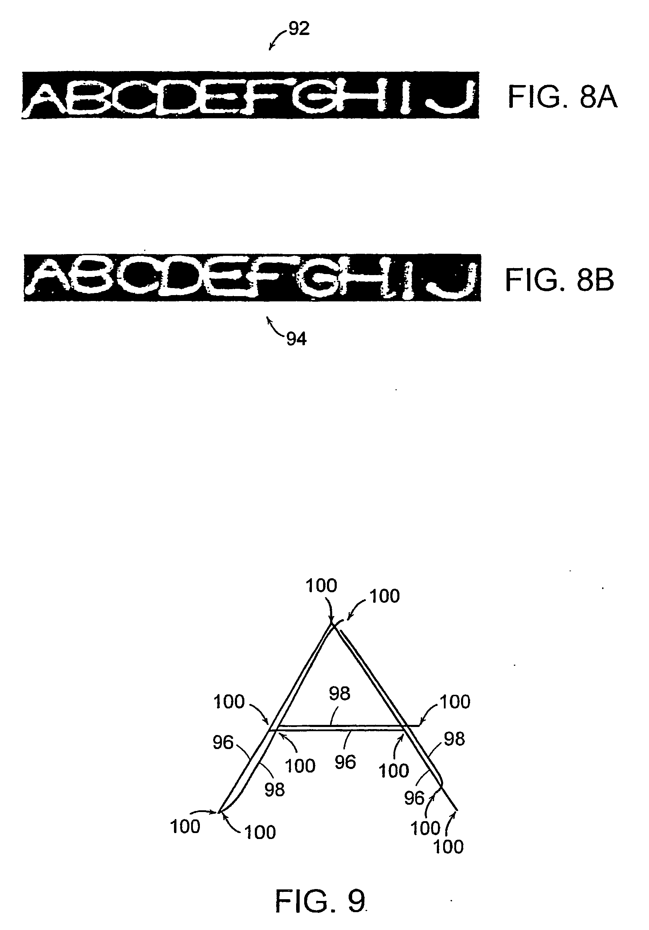

Because servo systems have finite tracking capabilities, for a fixed MD value, the higher the MS value, the faster the marking speed. However, the higher marking speed is achieved at the expense of a degraded marking quality. Figures 8A and 8B show scanned images of actual markings of the same pattern at two different speeds with MD equal to zero. It is observed that the pattern 92 marked at lower speed in Figure 8A has higher quality with better defined corners in each character than the pattern 94 marked at higher speed as shown in Figure 8B.

Since the marking speed is determined not only by the MS value but also by the MD value, there are many combinations of the MS and MD values that result in the same marking speed (i.e., total marking speed = MS + MD and total jump speed = JS + JD). Applicant has discovered that there exists a set of MS and MD that gives the best marking value. It is also desirable in some applications to find the maximum marking speed achievable at an accepted marking quality level.

The basic concept of evaluating marking quality is to compare the resulting marking with the reference pattern. This is achieved by reconstructing the reference pattern and the actual marked pattern from its corresponding time sequences. The trajectories of the actual marking are derived from only portions of the time responses of the scanner heads. This is because in character marking, as in many other vector marking applications, the laser beam is turned off for some moves of the scanner. The vector with dashed line in Figure 2 is an example of such a move or jump.

To quantify the marking errors, we divide each continuous marking spatially into equal length sections and form error vectors by connecting the corresponding division points between the reference marking and the actual markings.

For example, as shown in Figure 9, the commands for a marking (as shown at 96) may be compared with the actual marking (shown at 98) at a plurality of points (shown at 100). In accordance with an embodiment, the marking 96 may be physically recorded in an imaging medium at a slow total speed (mark speed plus mark delay), and the actual marking 98 may also be physically recorded in the imaging medium as well. The two recordings may be scanned and compared as discussed below. In accordance with further embodiments, the marking 96 may be created as a mathematical representation knowing the commands that are input to the system to create the mark. In this example, the actual markings 98 may be constructed from the drive signals that are provided to the X and Y motors. In accordance with further embodiments, the actual markings 98 may be generated without using a motor at all, but rather performing mathematical analyses that model the specific motors using specific parameters.

The differences (or error vectors) between the markings 96 and 98 at the error points may be generated by choosing an increment value for spacing between error vectors. For example, In accordance with an embodiment, the system may characterize each stroke vector of the markings 96 as a string of positions. The beginning and end of each stroke vector is identified, and the mid point along the stroke vector is also identified. If the stroke vector is rather long, the process may again identify a mid point in each half of the full stroke. The system would then characterize each stroke vector of the markings 98 as a string of positions and identify the ends and midpoint(s) as appropriate and as done with the markings 96. Each error vector is then defined as the distance between corresponding points on the markings 96 and 98.

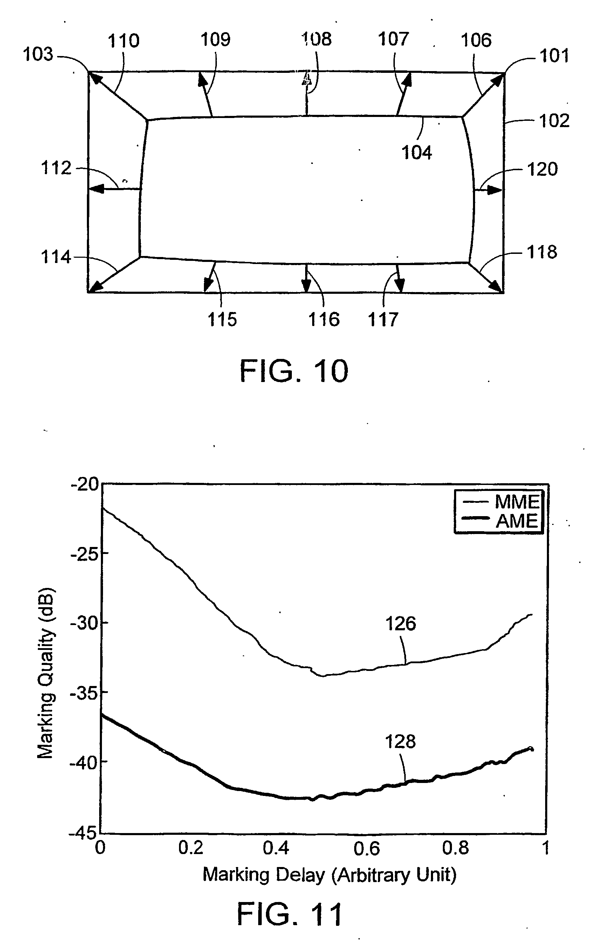

For example, Figure 10 shows an illustrative diagrammatic view of a reference mark 102 (in the form of a rectangle) and an actual mark 104. The end points of a first stroke are identified as 101 and 103. The midpoint of this stroke vector s identified and each half is again divided as the stroke vector is rather long. The corresponding stroke vectors of the actual mark 104 are also similarly divided into end and mid-points, and the error vectors are identified as extending between associated points. For example, the error vector 106 extends between first end points of the first stroke vector of each of the reference mark 102 and the reference mark 104. Such end point error vectors are identified, for example, at 106, 110, 114 and 118. Mid-point error vectors are identified at 107, 108, 109, 112, 115, 116, 117 and 120. The process of constructing the MME involves finding the maximum error (e.g.,110) and the process of constructing the AME involves finding the average of the 12 error vectors. If the number of mid-points becomes very high, the AME approaches the area between the reference mark 102 and the actual mark 104.

In accordance with further embodiments, error vectors may be determined in a grid pattern that covers the mark with a uniform spacing between each point of about 10 to 1000 micrometers. These error vectors may be quantified in a variety of ways. Again, the lengths of these error vectors defmed indicate the deviations of the actual marking from the reference marking.

Two evaluation functions of marking qualities may be employed to quantify the error vectors: Maximum Marking Error (MME) is defined as the maximal length of all the error vectors, while Average Marking Error (AME) is defined as the average of the lengths of all the error vectors. The MME, therefore, is the maximal deviation of the actual marking from the ideal marking. The AME, on the other hand, represents the marking errors for the entire pattern. In fact, for sufficiently large division numbers, AMR indicates the total area of the band formed by the reference marking and actual marking.

With the evaluation function defined, the optimal command sets for a given pattern may be determined by comparing the quality evaluation function values among all possible markings. Specifically, markings with different MS and MD settings for the desired pattern may be simulated, the marking speed together with the marking quality defined by the evaluation function values may be recorded.

For quality-optimal markings the command sets may be selected that give the smallest evaluation function numbers at a specified marking speed. For speed-optimal markings, the command set may be chosen that yields the highest marking speed at a pre-defined quality level.

Simulation and experimental results of command set optimization on commercially available marking heads show that scanning system may be optimized in accordance with the invention. The scanner model used in marking simulation is derived from the marking head used using system identification techniques. A string of "ABCDEFGHIJ" is used in the marking. Marking speed and marking delay settings are normalized. Larger values in MS and MD represent higher marking speed and longer mark delay period respectively. The marking quality values, i.e., MME and AME values, are normalized by the height of the characters marked and converted in decibels.

In marking quality optimization, the marking quality values MME and AME are calculated for all practical combinations of MS and MD that result in the given marking speed. Figure 6 shows the MME (at 126) and AMR (at 128) vs. MD at marking speed 617cps (characters-per-second). Compared with the standard command set with MD equals 0, we can see that the minimal marking error is obtained at the MD values around 0.5. This MD value corresponds to the MS settings of 1.4 times of the MS settings in the case of MD equals 0. With the optimal command set MME and AME are reduced by a factor of 4 and 2, respectively. Note that MME and AME reach minimal at very close regions of MD.

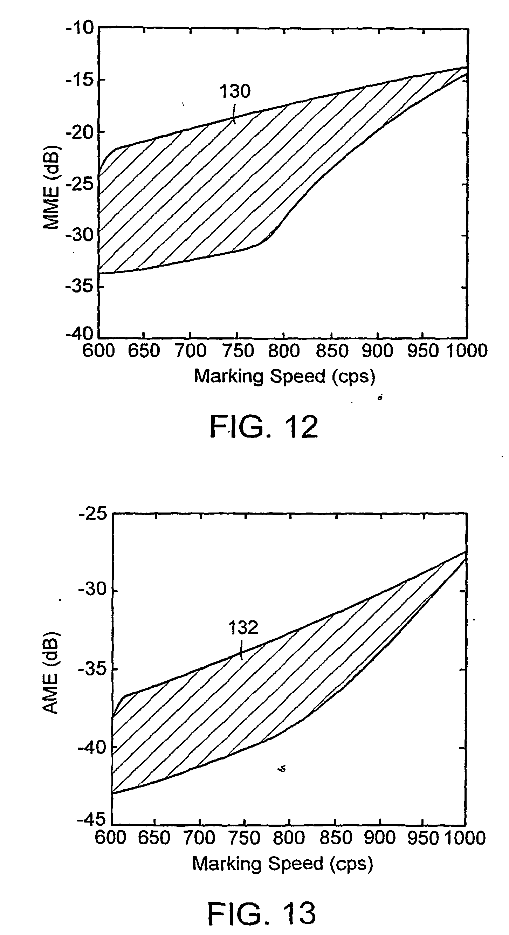

Figure 12 shows in the area indicated at 130 MME for all the practical combinations of MS and MD that result in different marking speeds. Figure 13 shows in the area indicated at 132 AME for all the practical combinations of MS and MD that result in different marking speeds. To find the maximal marking speed at a given marking quality, the lower boundary of the plot at the given marking quality value may be identified. For example, with the standard command set with MS=1 and MD=0 and marking speed 618cps, MME equals -22dB. At this quality level, the maximal marking speed can be achieved at 869cps. This is a 40% improvement in marking speed.

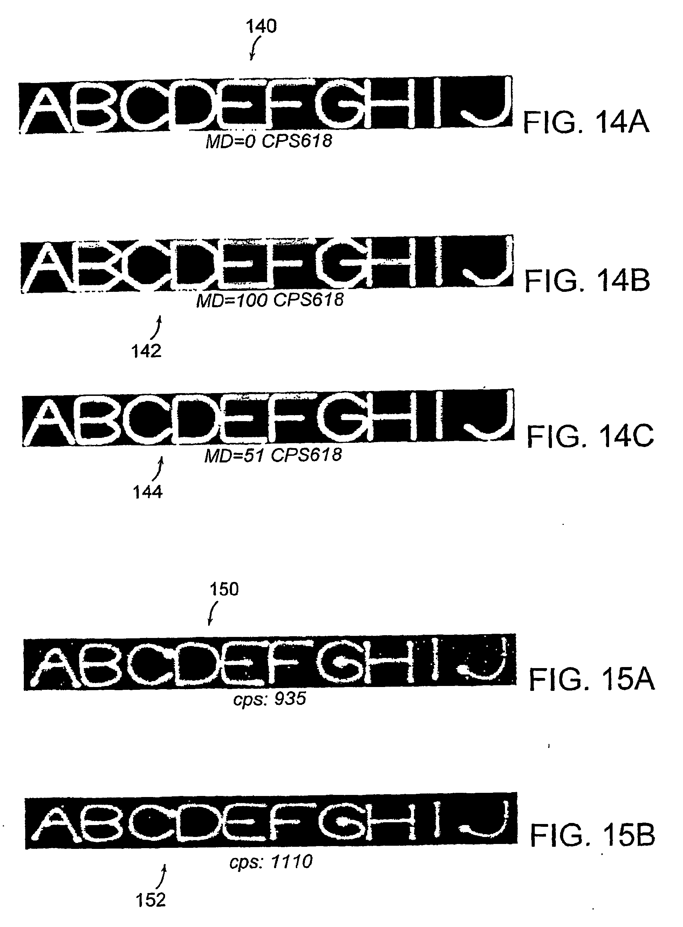

Figures 14A - 14C show simulated markings that results with and without the optimized command set. Figure 14A shows (at 140) the standard command setting with MD=0. Figure 14B shows (at 142) the optimized marking quality at the same speed as Figure 14A, while Figure 14C shows (at 144) the markings at 869cps at the quality of the markings in Figure 14A.

Figures 15A and 15B show the experimental results with a commercially available marking head for speed optimizations. The original marking speed for the marking (as shown at 150) in Figure 15A is 935cps, while the optimized marking speed for the marking (as shown at 152) in Figure 15B is 1110cps. The invention provides, therefore, a method of improving the character marking performance through command set optimization in accordance with various embodiments.

In accordance with another embodiment, the invention provides that the quality of a marking may be quantified by comparing the desired marking with a virtual marking rather than an actual marking. A virtual marking is one that is determined through mathematical modeling to represent the actual marking in a particular system under a particular set of parameters.

Upon quantifying the quality of a marking, the system may incrementally adjust one of MS, MD, JS, JD while maintaining either speed or quality fixed to determine the optimal set of parameters. The process is then repeated until the desired performance characteristic (speed or quality) begins to fall. In other embodiments, the system may employ a look-up table of previously recorded values, and simply look up the highest achievable speed or quality for the desired performance.

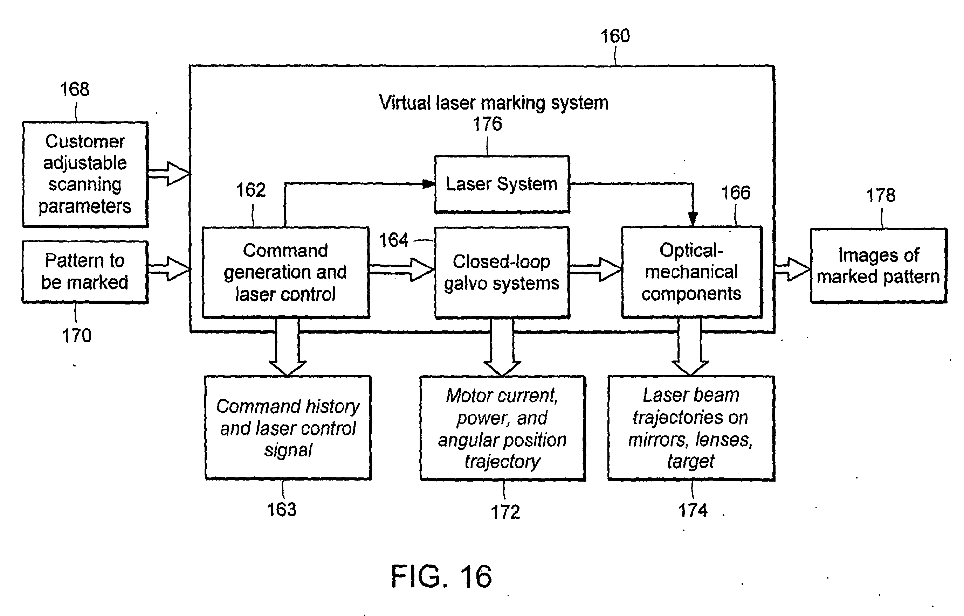

A virtual marking system is shown in Figure 16. Input commands are provided to a virtual limited rotation motor controller, and the virtual limited rotation motor controller provides output commands to a virtual motor, output shaft and mirror system. A position detection system records the position detection signals at the times that a laser would have been on, and thereby determines a virtual laser marking image.

A computer model, therefore, simulates the laser marking system. The virtual optical marker converts a specified pattern to be marked into the image of a marked pattern together with various real time signals of the marker in marking the given pattern. As shown in Figure 16, the system 160 includes a command generation and laser control unit 162 that provides pattern generation and laser control to translate a given multi-dimensional image into time sequences of mirror position commands together with laser control commands. The command generation and laser control unit 162 generates a command history and the laser control signal as shown at 163. The images of the marking are obtained by combining the laser control signal, beam trajectory, the laser type and the material to be marked.

The system 160 also includes a closed loop actuator system 164 that simulates the dynamic response of the beam-deflecting surfaces actuated by the motors, as well as optical-mechanical models or components 166 are employed to translate the mirror angle into beam trajectories on the target surface. The laser marking system receives customer adjustable scanning parameters via a parameter input unit 168 and a pattern to be marked via a pattern input 170. The closed-loop actuator system 164 provides the motor current, power, and angular position trajectory as shown at 172.

The optical-mechanical components provide laser beam trajectories on mirrors, lenses and the target as shown at 174. The system 160 may also include a laser system 176, and the system provides images of the marked patterns as shown at 178.

The independent laser control signal is derived as a timed data sequence representing the one and off status of the laser at any given time during the marking process. The motor system model simulates the time responses of the X and Y motor systems subject to the input command generated above. The primary output of the motor system model is the angular displacement of the X and Y mirrors represented by an array of angular position data together with the corresponding time values. Additional output from the motor system includes real time motor current and power dissipation of the motor system.

The optical path of the laser beam may be as shown in Figure 1 including a laser beam of a given diameter, optical lenses having defined characteristics, and relative positions among the mirrors, laser, lens, and target surface. The light intensity distributions on the mirror, lens and the target surface are also known. The laser beam is modeled by a Gaussian intensity pattern and is propagated along the path of the beam.

By combining the laser control signal and the mirror position trajectories, the laser light intensity profile trajectories on the mirror, lens and target surface may be constructed mathematically. The marked image is then obtained by shape and/or material property changes on the target surface as the result of the interaction between the surface material and laser intensity changes during the marking process.

The customer adjustable scanning parameters may include mark speed, which is the speed of the reference beam during marking, mark delay, which is the wait period at the end of each marking, jump speed, which is the speed of the reference beam during jump, jump delay, which is the wait period at then end of each jump, laser-on delay, which is the time difference between the beginning of reference marking and turning the laser beam on, and laser-off delay, which is the time difference between the end of reference marking and turning the laser beam off.

During operation, the specified pattern to be marked is first converted into a sequence of a laser beam positions. Next, the desired laser beam position is translated into angular positions of the X and Y axis mirror using the user specified marking parameters, including marking speed, mark delay, jump speed and jump delay. The desired mirror angular position commands are represented by an array of position values together with the corresponding time values. A pattern to be marked may be defined as the desired trajectory of the mirror positions with its corresponding mark and jump control.

The command generation and laser control unit 162 converts the pattern into the position commands to the scan head using the user defined scanning parameters, i.e., MS, MD, JS, JD, Laser-On and Laser-Off. These commands are represented by a time-stamped sequence of reference mirror positions of both the X and Y axis. The sequence of laser on/off control is also generated using the Laser-On and Laser-Off control parameters. Note that the following relationships exist between the above parameters: MS*MS=MSx*MSx + MSy*MSy and JS*JS=JSx*JSx + JSy*JSy.

The positions of the X and Y mirrors are generated using the closed-loop system model of the motor system. There are different ways of representing the system model for the purpose of simulating the time response of the optical scanners. These include a set of differential/difference equations, transfer functions, state space matrices, frequency response data, and graphical system models such as the model discussed below. The mathematical model of the closed-loop motor system 164 may either be derived from physical laws or be identified from real system measurements, or may be formed as a combination of both. The purpose is to simulate the dynamic response of the motor system when commanded with the command signals generated by the command generation and laser control system 162.

The optical-mechanical components 166 convert a given mirror position into the position of the laser beam on the marking surface. This is done by modeling the laser beam from the laser source as a set of parallel lines in the space. The mirrors are then modeled as the planes in the space. First, the beam landing on the focusing lens is calculated as lines reflected by two planes defined by the x and y mirror positions. Next, beam position and shape on the marking surface is calculated using the optical equations that govern the lens used. For example, for standard lenses, the in and out beam follows the cosine rule, and the F-theta lenses, the out beam angle is proportional to the angle of the in beam. Laser control is used in determining whether or not a beam spot should be formed on the marking surface.

The trajectory of the laser spot on the marking surface is then used to form the image of markings. This is done by linear superposition of beam spots of all the beams landed on a given area of the marking surface during the entire process of marking. Mathematically, this is done by a multidimensional convolution.

Those skilled in the art will appreciate that numerous modifications and variations may be made to the above disclosed embodiments without departing from the scope of the invention, as defined in the following claims.

## Claims

1. An optimization system for optimizing the performance of a laser marking system, said laser marking system comprising an XY laser scanner that employs two limited rotation motors (12, 14) that are coupled to mirrors (13) and (15) respectively for guiding a laser beam (16) that is produced by a laser source (18) through an imaging lens (20) toward an imaging surface (22), and being capable of producing a marking pattern comprising small line segments called marks which are produced when said laser impacts a target material at the imaging surface while the scanner moves the laser beam under the influence of a constant speed ramp command, the production of each mark being followed by a fixed delay time, during which the laser impacts the target material at the imaging surface while the scanner rests, the speed of the laser beam during the marking being called the mark speed, and the delay time being called the mark delay, said laser marking system being further capable of producing a movement of the scanner during which the laser beam does not impact the target material, being called a jump, and having a corresponding jump speed and jump delay, and where the marking speed is defined as being the total time from the beginning of marking the pattern to the end of marking the pattern;
said optimization system being **characterized** as comprising:
input means for receiving input parameters including mark speed, mark delay, jump speed, and jump delay;
pattern input means for receiving pattern data (70,74, 80, 84, 96) representative of a pattern to be marked; and
evaluation means arranged to compare said pattern data (70, 74, 80, 84, 96) with simulated marking results (72, 76, 82, 86, 98) based on all practical settings of mark speed, mark delay, jump speed, and jump delay, thereby identifying a particular combination of mark speed, mark delay, jump speed and jump delay, that achieves either
an optimal marking speed, being the highest marking speed that maintains a specified marking quality, or
an optimal marking quality, being the best quality marking among all markings of the same speed.

2. The optimizing system as claimed in claim 1, wherein said evaluation means identifies an optimal marking speed for achieving a desired marking quality.

3. The optimizing system as claimed in claim 1, wherein said evaluation means identifies an optimal marking quality for achieving a desired marking speed.

4. The optimization system as claimed in claim 1, wherein said optimization means further includes tuning means for changing at least one of the mark speed, mark delay, jump speed and jump delay responsive to the evaluation means.

5. The optimization system as claimed in claim 1, wherein said evaluation means includes means for determining an average marking error.

6. The optimization system as claimed in claim 1, wherein said evaluation means includes means for determining a maximum marking error.

7. The optimization system as claimed in claim 1, wherein said laser marking system includes actual marking means (10) for providing actual marking data to be evaluated by the evaluation means.

8. The optimization system as claimed in claim 1, wherein said laser marking system includes virtual marking means (160) for providing virtual marking data to be evaluated by the evaluation means.

9. The optimization system as claimed in claim 1, wherein said evaluation means includes error vector generation means for generating error vectors that are representative of differences between data representative of the pattern to be marked and the marked pattern data.

10. A method of optimizing the performance of a laser marking system, said laser marking system comprising an XY laser scanner that employs two limited rotation motors (12, 14) that are coupled to mirrors (13) and (15) respectively for guiding a laser beam (16) that is produced by a laser source (18) through an imaging lens (20) toward an imaging surface (22), and being capable of producing a marking pattern comprising small line segments called marks which are produced when said laser impacts a target material at the imaging surface while the scanner moves the laser beam under the influence of a constant speed ramp command, the production of each mark being followed by a fixed delay time, during which the laser impacts the target material at the imaging surface while the scanner rests, the speed of the laser beam during the marking being called the mark speed, and the delay time being called the mark delay, said laser marking system being further capable of producing a movement of the scanner during which the laser beam does not impact the target material, being called a jump, and having a corresponding jump speed and jump delay, and where the marking speed is defined as being the total time from the beginning of marking the pattern to the end of marking the pattern;
said method being **characterized** as comprising the steps of:
receiving input parameters including mark speed, mark delay, jump speed and jump delay;
receiving pattern data (70, 74, 80,84,96) representative of a pattern to be marked; and
comparing said pattern data (70, 74, 80, 84, 96) with simulated marking results (72, 76, 82, 86, 98) based on all practical settings of mark speed, mark delay, jump speed, and jump delay, thereby identifying a particular combination of mark speed, mark delay, jump speed and jump delay, that achieves either
an optimal marking speed, being the highest marking speed that maintains a specified marking quality, or
an optimal marking quality, being the best quality marking among all markings of the same speed.

11. The method as claimed in claim 10, wherein said step of identifying one of an optimal marking speed or marking quality for achieving a desired marking performance involves identifying an optimal marking speed for achieving a desired marking quality.

12. The method as claimed in claim 10, wherein said step of identifying one of an optimal marking speed or marking quality for achieving a desired marking performance involves identifying an optimal marking quality for achieving a desired marking speed.

13. The method as claimed in claim 10, wherein said method further includes the step of changing at least one of the mark speed, mark delay, jump speed and jump delay responsive to either the optimal marking speed or the optimal marking quality.

14. The method as claimed in claim 10, wherein said step of identifying one of an optimal marking speed or marking quality for achieving a desired marking performance involves determining an average marking error.

15. The method as claimed in claim 10, wherein said step of identifying one of an optimal marking speed or marking quality for achieving a desired marking performance involves determining a maximum marking error.

16. The method as claimed in claim 10, wherein said method further includes the step of providing actual marking data.

17. The method as claimed in claim 10, wherein said method further includes the step of providing virtual marking data.

18. The method as claimed in claim 10, wherein said method further includes the step of generating error vectors that are representative of differences between data representative of the pattern to be marked and the marked pattern data.

## Patentansprüche

1. Ein Optimierungssystem zum Optimieren der Leistung eines Lasermarkiersystems, wobei dieses Lasermarkiersystem einen XY-Laserscanner umfasst, welcher zwei Drehmotoren begrenzter Rotation (12, 14) verwendet, die jeweils mit Spiegeln (13 beziehungsweise 15) gekoppelt sind, um einen von einer Laserquelle (18) erzeugten Laserstrahl (16) durch eine bildgebende Linse (20) zu einer Abbildungsoberfläche (22) hin zu führen, und das in der Lage ist, ein Markiermuster zu bilden, das kleine Liniensegmente, Markierungen genannt, umfasst, die entstehen, wenn der Laser an der Abbildungsoberfläche auf ein Zielmaterial trifft, während der Scanner den Laserstrahl unter dem Einfluss eines Befehls für einen konstanten Geschwindigkeitsanstieg bewegt, wobei nach der Erstellung einer jeden Markierung eine festgesetzte Verzögerungszeit folgt, während welcher der Laser an der Abbildungsoberfläche auf ein Zielmaterial trifft, während der Scanner ruht, wobei die Geschwindigkeit des Laserstrahls während des Markierens Markierungsgeschwindigkeit und die Verzögerungszeit Markierungsverzögerung genannt wird, und das Lasermarkiersystem des weiteren in der Lage ist, eine Bewegung des Scanners zu erzeugen, während welcher der Laserstrahl nicht auf das Zielmaterial auftrifft, was als ein Sprung bezeichnet wird, wozu es dementsprechend eine Sprunggeschwindigkeit und eine Sprungverzögerung gibt, und wobei die Markiergeschwindigkeit als die Gesamtzeit vom Beginn des Markierens des Musters bis zum Ende des Markierens des Musters definiert ist;
wobei das Optimierungssystem **dadurch gekennzeichnet ist, dass** es folgendes umfasst:
Eingabemittel zum Empfangen von Eingabeparametern, unter Einbeziehung von Markierungsgeschwindigkeit, Markierungsverzögerung, Sprunggeschwindigkeit und Sprungverzögerung;
Mustereingabemittel zum Empfangen von Musterdaten (70, 74, 80, 84, 96), welche ein zu markierendes Muster darstellen; und
Auswertungsmittel, die zum Vergleichen der Musterdaten (70, 74, 80, 84, 96) mit simulierten Markierungsergebnissen (72, 76, 82, 86, 98) angebracht sind, die auf allen zweckmäßigen Einstellungen von Markierungsgeschwindigkeit, Markierungsverzögerung, Sprunggeschwindigkeit und Sprungverzögerung basieren und **dadurch** eine besondere Kombination von Markierungsgeschwindigkeit, Markierungsverzögerung, Sprunggeschwindigkeit und Sprungverzögerung identifizieren, die entweder
eine optimale Markiergeschwindigkeit erzielt, die die höchste Markiergeschwindigkeit ist, die eine spezifische Markierqualität beibehält, oder
eine optimale Markierqualität erzielt, die die Markierung der besten Qualität von allen Markierungen der selben Geschwindigkeit ist.

2. Optimierungssystem nach Anspruch 1, **dadurch gekennzeichnet, dass** das Auswertungsmittel eine optimale Markiergeschwindigkeit zum Erreichen einer gewünschten Markierqualität aufzeigt.

3. Optimierungssystem nach Anspruch 1, **dadurch gekennzeichnet, dass** das Auswertungsmittel eine optimale Markierqualität zum Erreichen einer gewünschten Markiergeschwindigkeit aufzeigt.

4. Optimierungssystem nach Anspruch 1, **dadurch gekennzeichnet, dass** das Optimierungmittel des weiteren Einstellungsmittel zum Wechseln von mindestens einer der Markierungsgeschwindigkeit, Markierungsverzögerung, Sprunggeschwindigkeit und Sprungverzögerung umfasst, die auf das Auswertungsmittel reagiert.

5. Optimierungssystem nach Anspruch 1, **dadurch gekennzeichnet, dass** das Auswertungsmittel Mittel zur Feststellung eines durchschnittlichen Markierfehlers umfasst.

6. Optimierungssystem nach Anspruch 1, **dadurch gekennzeichnet, dass** das Auswertungsmittel Mittel zur Feststellung eines maximalen Markierfehlers umfasst.

7. Optimierungssystem nach Anspruch 1, **dadurch gekennzeichnet, dass** das Lasermarkiersystem reale Markiermittel (10) umfasst, um reale Markierdaten zu erzeugen, die durch die Auswertungsmittel ausgewertet werden sollen.

8. Optimierungssystem nach Anspruch 1, **dadurch gekennzeichnet, dass** das Lasermarkiersystem virtuelle Markiermittel (160) umfasst, um virtuelle Markierdaten zu erzeugen, die durch die Auswertungsmittel ausgewertet werden sollen.

9. Optimierungssystem nach Anspruch 1, **dadurch gekennzeichnet, dass** das Auswertungsmittel Mittel zur Erzeugung von Fehlervektoren umfasst, die Fehlervektoren erzeugen, welche Differenzen zwischen den die zu markierenden Muster widerspiegelnden Daten und den die markierten Muster widerspiegelnden Daten darstellen.

10. Ein Verfahren zur Optimierung der Leistung eines Lasermarkiersystems, wobei das Lasermarkiersystem einen XY-Laserscanner umfasst, welcher zwei Drehmotoren begrenzter Rotation (12, 14) verwendet, die jeweils mit Spiegeln (13 beziehungsweise 15) gekoppelt sind, um einen von einer Laserquelle (18) erzeugten Laserstrahl (16) durch eine bildgebende Linse (20) zu einer Abbildungsoberfläche (22) hin zu führen, und das in der Lage ist, ein Markiermuster zu bilden, das kleine Liniensegmente, Markierungen genannt, umfasst, die entstehen, wenn der Laser an der Abbildungsoberfläche auf ein Zielmaterial trifft, während der Scanner den Laserstrahl unter dem Einfluss eines Befehls für einen konstante Geschwindigkeitsanstieg bewegt, wobei nach der Erstellung einer jeden Markierung eine festgesetzte Verzögerungszeit folgt, während welcher der Laser an der Abbildungsoberfläche auf ein Zielmaterial trifft, während der Scanner ruht, wobei die Geschwindigkeit des Laserstrahls während des Markierens Markierungsgeschwindigkeit und die Verzögerungszeit Markierungsverzögerung genannt wird, und das Lasermarkiersystem des weiteren in der Lage ist, eine Bewegung des Scanners zu erzeugen, während welcher der Laserstrahl nicht auf das Zielmaterial auftrifft, was als ein Sprung bezeichnet wird, wozu es dementsprechend eine Sprunggeschwindigkeit und eine Sprungverzögerung gibt, und wobei die Markiergeschwindigkeit als die Gesamtzeit vom Beginn des Markierens des Musters bis zum Ende des Markierens des Musters definiert ist;
wobei das Verfahren **dadurch gekennzeichnet ist, dass** es folgende Schritte umfasst:
Empfangen von Eingabeparametern, unter Einbeziehung von Markierungsgeschwindigkeit, Markierungsverzögerung, Sprunggeschwindigkeit und Sprungverzögerung;
Empfangen von Musterdaten (70, 74, 80, 84, 96), welche ein zu markierendes Muster darstellen; und
Vergleichen der Musterdaten (70, 74, 80, 84, 96) mit simulierten Markierungsergebnissen (72, 76, 82, 86, 98), die auf allen zweckmäßigen Einstellungen von Markierungsgeschwindigkeit, Markierungsverzögerung, Sprunggeschwindigkeit und Sprungverzögerung basieren, wodurch eine besondere Kombination von Markierungsgeschwindigkeit, Markierungsverzögerung, Sprunggeschwindigkeit und Sprungverzögerung identifiziert wird, die entweder
eine optimale Markiergeschwindigkeit erzielt, die die höchste Markiergeschwindigkeit ist, die eine spezifische Markierqualität beibehält, oder
eine optimale Markierqualität erzielt, die die Markierung der besten Qualität von allen Markierungen der selben Geschwindigkeit ist.

11. Verfahren nach Anspruch 10, **dadurch gekennzeichnet, dass** der Schritt der Identifizierung einer optimalen Markiergeschwindigkeit oder Markierqualität zum Erreichen einer gewünschten Markierleistung die Identifizierung einer optimalen Markiergeschwindigkeit zum Erreichen einer gewünschten Markierqualität beinhaltet.

12. Verfahren nach Anspruch 10, **dadurch gekennzeichnet, dass** der Schritt der Identifizierung einer optimalen Markiergeschwindigkeit oder Markierqualität zum Erreichen einer gewünschten Markierleistung die Identifizierung einer optimalen Markierqualität zum Erreichen einer gewünschten Markiergeschwindigkeit beinhaltet.

13. Verfahren nach Anspruch 10, **dadurch gekennzeichnet, dass** das Verfahren des weiteren den Schritt des Wechsels von mindestens einer der Markierungsgeschwindigkeit, Markierungsverzögerung, Sprunggeschwindigkeit und Sprungverzögerung, als Reaktion entweder auf die optimale Markiergeschwindigkeit oder die optimale Markierqualität umfasst.

14. Verfahren nach Anspruch 10, **dadurch gekennzeichnet, dass** der Schritt der Identifizierung einer optimalen Markiergeschwindigkeit oder einer optimalen Markierqualität zum Erreichen einer gewünschten Markierleistung das Festlegen eines durchschnittlichen Markierfehlers einbezieht.

15. Verfahren nach Anspruch 10, **dadurch gekennzeichnet, dass** der Schritt der Identifizierung einer optimalen Markiergeschwindigkeit oder einer optimalen Markierqualität zum Erreichen einer gewünschten Markierleistung das Festlegen eines maximalen Markierfehlers einbezieht.

16. Verfahren nach Anspruch 10, **dadurch gekennzeichnet, dass** das Verfahren des weiteren den Schritt der Lieferung von realen Markierdaten umfasst.

17. Verfahren nach Anspruch 10, **dadurch gekennzeichnet, dass** das Verfahren des weiteren den Schritt der Lieferung von virtuellen Markierdaten umfasst.

18. Verfahren nach Anspruch 10, **dadurch gekennzeichnet, dass** das Verfahren des weiteren den Schritt der Erzeugung von Fehlervektoren umfasst, welche die Unterschiede zwischen den Daten, welche die zu markierenden Muster darstellen, und den Daten, welche die markierten Muster darstellen, wiedergeben.

## Revendications

1. Système d'optimisation destiné à optimiser les performances d'un système de marquage au laser, ledit système de marquage au laser comprenant un scanner au laser XY qui utilise deux moteurs à rotation limitée (12, 14) qui sont accouplés à des miroirs (13) et (15) respectivement pour guider un faisceau laser (16) qui est produit par une source laser (18) à travers une lentille d'imagerie (20) vers une surface d'imagerie (22), et ayant la capacité de produire un motif de marquage comprenant de petits segments de ligne nommés marques qui sont produits lorsque ledit laser entre en collision avec un matériau cible sur la surface d'imagerie, tandis que le scanner déplace le faisceau laser sous l'influence d'une commande de montée de vitesse constante, la production de chaque marque étant suivie d'un délai d'attente fixe, pendant lequel le laser entre en collision avec le matériau cible sur la surface d'imagerie pendant que le scanner est au repos, la vitesse du faisceau laser pendant le marquage étant nommée vitesse de marquage et le délai d'attente étant nommé délai de marquage, ledit système de marquage au laser ayant en outre la capacité de produire un déplacement du scanner pendant lequel le faisceau laser n'entre pas en collision avec le matériau cible, nommé saut et ayant une vitesse de saut et un délai de saut correspondants, et où la vitesse de marquage est définie comme étant le temps total depuis le début du marquage du motif jusqu'à la fin du marquage du motif ;
ledit système d'optimisation étant **caractérisé en ce qu'**il comprend :
un moyen d'entrée destiné à recevoir des paramètres d'entrée, à savoir la vitesse de marquage, le délai de marquage, la vitesse de saut et le délai de saut ;
un moyen d'entrée de motif destiné à recevoir des données de motif (70, 74, 80, 84, 96) représentatives d'un motif à marquer ; et
un moyen d'évaluation configuré pour comparer lesdites données de motif (70, 74, 80, 84, 96) avec des résultats de marquage simulés (72, 76, 82, 86, 98), en se basant sur tous les réglages pratiques de vitesse de marquage, de délai de marquage, de vitesse de saut et de délai de saut, en identifiant ainsi une combinaison particulière de vitesse de marquage, de délai de marquage, de vitesse de saut et de délai de saut, pour obtenir soit
une vitesse de marquage optimale, qui est la vitesse de marquage la plus élevée préservant une qualité de marquage spécifiée, soit
une qualité de marquage optimale, qui est le marquage ayant la meilleure qualité parmi tous les marquages effectués à la même vitesse.

2. Système d'optimisation selon la revendication 1, dans lequel ledit moyen d'évaluation identifie une vitesse de marquage optimale pour obtenir une qualité de marquage souhaitée.

3. Système d'optimisation selon la revendication 1, dans lequel ledit moyen d'évaluation identifie une qualité de marquage optimale pour obtenir une vitesse de marquage souhaitée.

4. Système d'optimisation selon la revendication 1, dans lequel ledit moyen d'optimisation comprend un moyen de réglage pour modifier au moins un parmi la vitesse de marquage, le délai de marquage, la vitesse de saut et le délai de saut en réponse au moyen d'évaluation.

5. Système d'optimisation selon la revendication 1, dans lequel ledit moyen d'évaluation comprend un moyen pour déterminer une erreur de marquage moyenne.

6. Système d'optimisation selon la revendication 1, dans lequel ledit moyen d'évaluation comprend un moyen pour déterminer une erreur de marquage maximale.

7. Système d'optimisation selon la revendication 1, dans lequel ledit système de marquage au laser comprend un moyen de marquage réel (10) pour fournir des données de marquage réelles devant être évaluées par le moyen d'évaluation.

8. Système d'optimisation selon la revendication 1, dans lequel ledit système de marquage au laser comprend un moyen de marquage virtuel (160) pour fournir des données de marquage virtuelles devant être évaluées par le moyen d'évaluation.

9. Système d'optimisation selon la revendication 1, dans lequel ledit moyen d'évaluation comprend un moyen de génération de vecteurs d'erreurs pour générer des vecteurs d'erreurs représentatifs des différences entre les données représentatives du motif à marquer et les données de motif marquées.

10. Procédé d'optimisation des performances d'un système de marquage au laser, ledit système de marquage au laser comprenant un scanner au laser XY utilisant deux moteurs à rotation limitée (12, 14) qui sont accouplés aux miroirs (13) et (15) respectivement pour guider un faisceau laser (16) qui est produit par une source laser (18) à travers une lentille d'imagerie (20) vers une surface d'imagerie (22) et ayant la capacité de produire un motif de marquage comprenant des petits segments de ligne nommés marques qui sont produits lorsque ledit laser entre en collision avec un matériau cible sur la surface d'imagerie tandis que le scanner déplace le faisceau laser sous l'influence d'une commande de rampe de vitesse constante, la production de chaque marque étant suivie d'un délai d'attente fixe, pendant lequel le laser entre en collision avec le matériau cible sur la surface d'imagerie pendant que le scanner est au repos, la vitesse du faisceau laser pendant le marquage étant nommée vitesse de marquage et le délai d'attente étant nommé délai de marquage, ledit système de marquage au laser ayant outre la capacité de produire un déplacement du scanner pendant lequel le faisceau laser n'entre pas en collision avec le matériau cible, nommé saut et ayant une vitesse de saut et un délai de saut correspondants et la vitesse de marquage étant définie comme étant le temps total depuis le début du marquage du motif jusqu'à la fin du marquage du motif ;
ledit procédé étant **caractérisé en ce qu'**il comprend les étapes consistant à :
recevoir des paramètres d'entrée, à savoir la vitesse de marquage, le délai de marquage, la vitesse de saut et le délai de saut ;
recevoir des données de motif (70, 74, 80, 84, 96) représentatives d'un motif à marquer ; et
comparer lesdites données de motif (70, 74, 80, 84, 96) avec les résultats de marquage simulés (72, 76, 82, 86, 98) en se basant sur tous les réglages pratiques de vitesse de marquage, de délai de marquage, de vitesse de saut et de délai de saut, et
identifier ainsi une combinaison particulière de vitesse de marquage, de délai de marquage, de vitesse de saut et de délai de saut, pour obtenir soit
une vitesse de marquage optimale, qui est la vitesse de marquage la plus élevée préservant une qualité de marque spécifiée, soit
une qualité de marquage optimale, qui est le marquage ayant la meilleure qualité parmi tous les marquages effectués à la même vitesse.

11. Procédé selon la revendication 10, dans lequel ladite étape d'identification d'une vitesse de marquage optimale ou d'une qualité de marquage optimale pour obtenir des performances de marquage souhaitées comprend l'identification d'une vitesse de marquage optimale pour obtenir une qualité de marquage souhaitée.

12. Procédé selon la revendication 10, dans lequel ladite étape d'identification d'une vitesse de marquage optimale ou d'une qualité de marquage optimale pour obtenir des performances de marquage souhaitées comprend l'identification d'une qualité de marquage optimale pour obtenir une vitesse de marquage souhaitée.

13. Procédé selon la revendication 10, dans lequel ledit procédé comprend en outre l'étape de modification d'au moins un parmi la vitesse de marquage, le délai de marquage, la vitesse de saut et le délai de saut en réponse à la vitesse de marquage optimale ou à la qualité de marquage optimale.

14. Procédé selon la revendication 10, dans lequel ladite étape d'identification d'une vitesse de marquage optimale ou d'une qualité de marquage optimale pour obtenir des performances de marquage souhaitées comprend la détermination d'une erreur de marquage moyenne.

15. Procédé selon la revendication 10, dans lequel ladite étape d'identification d'une vitesse de marquage optimale ou d'une qualité de marquage optimale pour obtenir des performances de marquage souhaitées comprend la détermination d'une erreur de marquage maximale.

16. Procédé selon la revendication 10, dans lequel ledit procédé comprend en outre l'étape consistant à fournir des données de marquage réelles.

17. Procédé selon la revendication 10, dans lequel ledit procédé comprend en outre l'étape consistant à fournir des données de marquage virtuelles.

18. Procédé selon la revendication 10, dans lequel ledit procédé comprend en outre l'étape consistant à générer des vecteurs d'erreurs qui sont représentatifs de différences entre les données représentatives du motif à marquer et les données de motif marquées.
